# EUROPEAN PATENT SPECIFICATION

(11) **EP 4 201 574 B1**
(45) Date of publication and mention of the grant of the patent: **04.03.2026**
(21) Application number: 22212604.7
(22) Date of filing: 09.12.2022
(51) Int. Cl.: H05K 3/20, H10F 77/20, H05K 1/09

(54) **PATTERN TRANSFER PRINTING OF MULTI-LAYERED FEATURES**
MUSTERÜBERTRAGUNGSDRUCK VON MEHRSCHICHTIGEN MERKMALEN
IMPRESSION PAR TRANSFERT DE MOTIF DE CARACTÉRISTIQUES MULTICOUCHES

(30) Priority: 27.12.2021 IL 28942821; 27.12.2021 US 202117562360; 28.12.2021 CN 202123363593 U
(43) Date of publication of application: 28.06.2023
(73) Proprietor: Wuhan Dr Laser Technology Corp., Ltd., Wuhan 430078 (CN)
(72) Inventor: COHEN, Eyal, 4420801 1 Keren Avraham St., Kfar-Saba (IL); FINAROV, Moshe, 7647013 16/7 Einstein Street, Rechovot (IL)
(74) Representative: Pearl Cohen UK

(56) References cited:
- EP-A1- 2 660 352
- WO-A2-2009/153792
- JP-A- H07 169 635
- US-A1- 2004 110 321
- US-A1- 2019 019 736

## Description

### 1. TECHNICAL FIELD

The present invention relates to the field of transfer printing, and more particularly, to printing multi-layered features.

### 2. DISCUSSION OF RELATED ART

U.S. Patent No. 9,616,524, teaches a method of depositing a material on a receiving substrate, the method comprising: providing a source substrate having a back surface and a front surface, the back surface carrying at least one piece of coating material; providing a receiving substrate positioned adjacent to the source substrate and facing the coating material; and radiating light towards the front surface of the source substrate, to remove at least one piece of the coating material from the source substrate and deposit said removed at least one piece onto the receiving substrate as a whole.

Lossen et al. (2015), Pattern Transfer Printing (PTP™) for c-Si solar cell metallization, 5th Workshop on Metallization for Crystalline Silicon Solar Cells, Energy Procedia 67:156-162, teaches pattern transfer printing (PTP^{™}) as a non-contact printing technology for advanced front side metallization of c-Si PV solar cells, which is based on laser-induced deposition from a polymer substrate. Other prior art documents are EP2660352A1; WO2009/153792A2; US2019/0019736A1; JPH07169635A.

### SUMMARY OF THE INVENTION

The following is a simplified summary providing an initial understanding of the invention. The summary does not necessarily identify key elements nor be used to limit the scope of the invention, but merely serves as an introduction to the following description.

One aspect of the present invention provides a pattern transfer sheet according to appended claim 1.

One aspect of the present invention provides a pattern transfer method according to appended claim 9.

These, additional, and/or other aspects and/or advantages of the present invention are set forth in the detailed description which follows; inferable from the detailed description; and/or learnable by practice of the present invention.

### BRIEF DESCRIPTION OF THE DRAWINGS

For a better understanding of embodiments of the invention and to show how the same may be carried into effect, reference will now be made, purely by way of example, to the accompanying drawings in which like numerals designate corresponding elements or sections throughout.

In the accompanying drawings:
**Figures 1****,** **2A** and **2B** are high-level schematic illustrations of pattern transfer sheets with multi-layered stacks of printing paste and pattern transfer methods, according to some embodiments of the invention.
**Figure 2C** is a high-level schematic illustration of a combination of paste filling heads including doctor blade dispensing and recirculating paste dispensing, according to some embodiments of the invention.
**Figure 2D** is a high-level schematic illustration of a combination of a paste filling unit in a pattern transfer printing (PTP) system, according to some embodiments of the invention.
**Figure 3A** provides an example for a multi-layered element produced by disclosed methods and systems, according to some embodiments of the invention.
**Figures 3B** and **3C** are high-level schematic illustrations of photovoltaic solar cells with multilayered conducting lines, according to some embodiments of the invention.
**Figures 4A** and **4B** are high-level flowchart illustrating pattern transfer methods, according to some embodiments of the invention.
**Figures 5A** and **5B** are high-level schematic side-view illustrations of a pattern transfer process for producing multi-layered features and utilizing a releasing layer, according to some embodiments of the invention.

### DETAILED DESCRIPTION OF THE INVENTION

In the following description, various aspects of the present invention are described. For purposes of explanation, specific configurations and details are set forth in order to provide a thorough understanding of the present invention. However, it will also be apparent to one skilled in the art that the present invention may be practiced without the specific details presented herein. Furthermore, well known features may have been omitted or simplified in order not to obscure the present invention. With specific reference to the drawings, it is stressed that the particulars shown are by way of example and for purposes of illustrative discussion of the present invention only, and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

Before at least one embodiment of the invention is explained in detail, it is to be understood that the invention is not limited in its application to the details of construction and the arrangement of the components set forth in the following description or illustrated in the drawings. The invention is applicable to other embodiments that may be practiced or carried out in various ways as well as to combinations of the disclosed embodiments. Also, it is to be understood that the phraseology and terminology employed herein are for the purpose of description and should not be regarded as limiting, the invention being defined by the appended claims.

Embodiments of the present invention provide efficient and economical methods and mechanisms for producing multi-layered features using transfer printing processes and thereby provide improvements to the technological field of producing electric circuits. Pattern transfer sheets and methods are provided, providing multi-layer paste stacks that are printed on a receiving substrate in a single illumination step. The paste is filled layer-by-layer, possibly having different materials in different layers, with layer thickness controlled by parameters of the filling elements, e.g., in case of blades, the pressure, angle, velocity and flexibility (material) of the blade. Specifically, a bottom layer of the stack may be configured to interface the receiving substrate while one or more top layers may be configured to optimize the quality of the printed features. For example, bottom layers may be configured to bind to the substrate (e.g., mechanically and/or electrically), to modify the substrate (e.g., forming selective emitter (SE) therein) and/or provide a barrier from top layer(s) which may not be compatible with the substrate (e.g., copper on silicon). Releasing material may be used to support the single step release of the stack. Advantageously, disclosed pattern transfer sheets and methods enable printing multi-layered conductive lines on PV cells as well as printing multi-layered bumps on PCB, printing resistors and capacitors and other printed electronics devices.

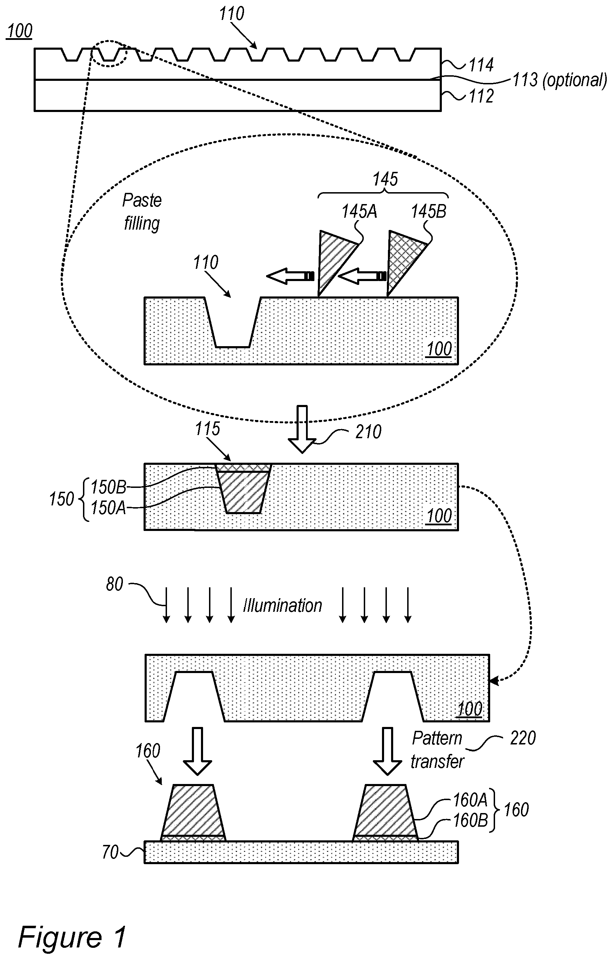

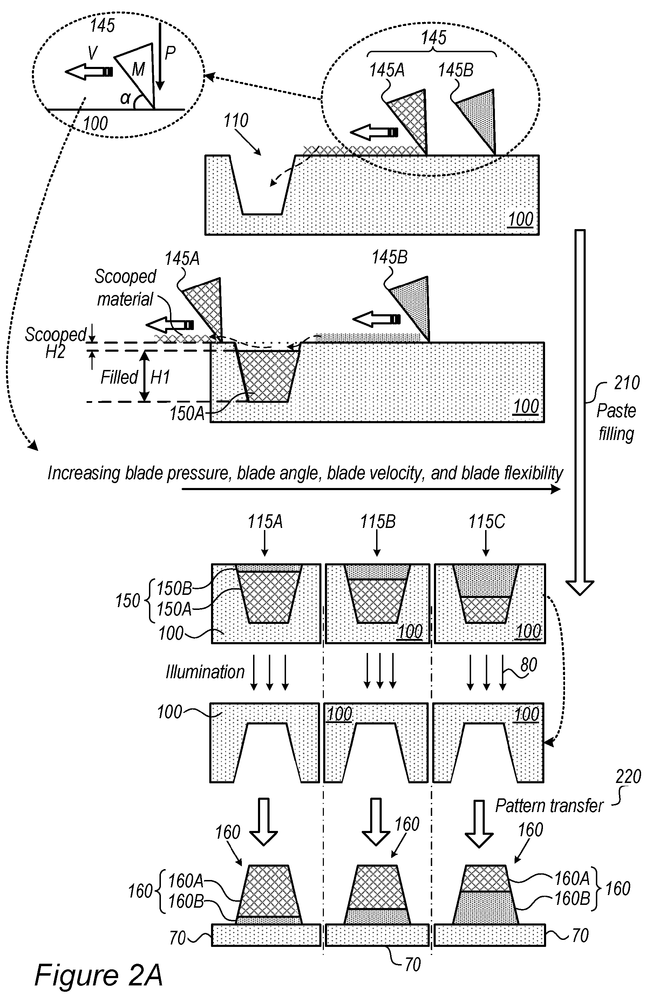

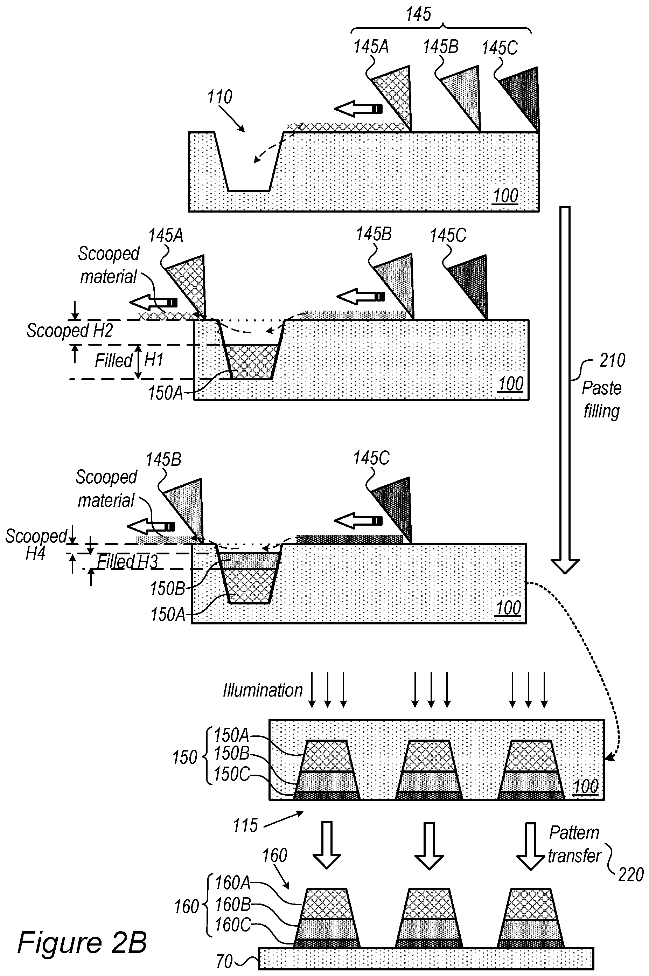

**Figures 1****,** **2A** and **2B** are high-level schematic illustrations of pattern transfer sheet 100 with a multi-layered stack **150** of printing paste and pattern transfer methods **200**, according to some embodiments of the invention. **Figure 1** illustrates schematically the paste filling and pattern transfer processes, while **Figure 2A** illustrates schematically process parameter adjustments for printing multi-layered stack **150** and **Figure 2B** illustrates schematically printing multi-layered stack **150** as a stack line with more than two layers. It is noted that for clarity reasons, only two layers **150A, 150B** are illustrated explicitly; disclosed embodiments however are not limited to two layers, and in various embodiments multi-layered stack **150** may comprise 3, 4, 5 or more layers, prepared and printed according to the principles disclosed herein. While some of the illustrations include for clarity a single trench **110** per sheet **100,** clearly any of the disclosed embodiments is applicable to sheets **100** with multiple trenches **110** arranged in specified patterns on sheet **100.**

Pattern transfer sheet **100** comprises a plurality of trenches **110** arranged in a specified pattern (pattern not shown and may be of any configuration). Trenches **110** are configured to be filled with printing paste and consecutively enable and support releasing the printing paste from trenches **110** onto a receiving substrate **70** upon illumination by a laser beam **80**. Pattern transfer sheet **100** comprises a source substrate that may be flexible (e.g., a polymer sheet) or rigid (e.g., a glass substrate). The supporting portion of the pattern transfer sheet **100** may be a stretchable substrate with certain stretching properties such as a polymer substrate, or the supporting portion of the pattern transfer sheet **100** may be a rigid substrate such as a glass substrate.

The printing paste comprises multi-layered stack **150** made of a plurality of layers **(150A, 150B,** and so forth) that is filled **210** into trenches **110** by one or more heads **145** to yield filled trenches **115,** and is transferred as a stack line onto receiving substrate **70** using a single illumination (pattern transfer) step **220**. Filling the printing paste into trenches **110** (stage denoted **210** may be carried out in a consecutive manner, layer-by-layer - as illustrated schematically.

In the illustrated non-limiting example, two layers **150** of printing paste are filled into trenches **110** consecutively, with a first paste material filled as layer **150A** into trenches **110,** e.g., using a doctor blade filling head **145A** with controlled scooping and removing of paste from the top part of trenches **110,** e.g., carried out by blade **145A** of the same head or alternatively by an additional moving blade (not illustrated). The depth of scooping maybe controlled, e.g., by the scooping blade material, blade angle, head pressure and head movement velocity. A second paste material may be filled on top of layer **150A** as layer **150B,** filling the remaining volume of trenches **110** to yield filled trenches **115** in case of two-layered implementations. Filling layer **150B** with the second paste material using a doctor blade filling head **145B** (followed by minimal or no scooping).

Consecutive patter transfer **220** using illumination **80** of pattern transfer sheet **100** from the back side thereof releases stack line **150** of the multi-layered paste from filled trenches **115** onto substrate **70** (e.g., wafer **70**) in a single stage (illustrated in **Figure 1** schematically, with sheet **100** facing down for releasing the paste) - to yield multi-layered elements **160** such as elements in electronics design, lines, fingers or bumps, made of layers **160B, 160A** of the second and first materials, in opposite order. Second paste layer **150B** becomes bottom layer **160B** contacting receiving substrate **70**, while first paste layer **150A** becomes top layer **160A** of feature **160.** It is noted that while inner layer **150A** typically contacts most of the surface area of trenches **110** in source substrate **100,** bottom layer **160B** typically provides the interface between feature **160** (formed from transferred stack line **150)** and receiving substrate **70**.

In various embodiments, more than two layers may be filled **240** in to trenches **110** and consecutively transfers, using single stage **250**, onto receiving substrate **70** to yield multi-layered features. For example, three, four, five or more layers may be part of multi-layered stack line **150** - yielding multi-layered elements **160.** In certain embodiments, the thickness of bottom layer **150A** may be between 1-5µm. Top layer **150B** may be several µm thick, e.g., within any of the ranges 3-5µm, 4-5µm, 4-7µm, 5-10µm, over 7µm, or any subranges thereof.

It is noted that any of heads **145** may comprise a recirculating paste dispensing head as described in Chinese Patent Applications Nos. 202110673006.5 and 202121350578.1. For example, heads **145** which are used to scoop an upper portion of the filled material (see, e.g., in following **Figures 2A****,** **2B****)** may comprise doctor blades configured to provide the required scooping, while head **145** filling the last layer (without scooping) may be a recirculating paste dispensing head.

**Figure 2A** further illustrates schematically various ways to control the thickness of the layers in stack **150** and consequently in feature **160,** according to some embodiments of the invention. For example, layer thickness may be controlled by any of the pressure apply by blades **145,** the angle of blades **145,** the velocity of blades **145** and/or the material blades **145** are made of. Specifically, the thickness of applied layer (denoted schematically H1, e.g., layer **150A)** decreases with higher blade pressure, with larger blade angle, with higher blade velocity and with softer blade material - leaving more volume to be filled by consecutive layer(s) **150B** (the volume thickness denoted schematically H2). As illustrated schematically in **Figure 1****,** the transfer of stack line **150** onto substrate **70** is carried out by illumination applied to the back of sheet **100,** placed directly above and in close proximity to substrate **70**.

In the illustrated examples, increasing blade pressure (P) of blade **145A** filling in layer **150A** from P=2.5bar to P=3.5bar (while keeping the blade pressure of blade **145B** filling in layer **150B** at 2bar) reduced the thickness of layer **150A,** leaving more volume to form thicker top layer **150B** (illustrated schematically as filled trenches **115A** and **115B** for lower and higher blade pressure, respectively). Correspondingly, in deposited features layer bottom **160A** became thicker and top layer **160B** became thinner as the filling blade pressure was increased. The reduction in thickness of layer **150A** with increased blade pressure was found to result from enhanced scooping with higher blade pressures, e.g., using Heraeus^{™} 9651B paste, P=2.5bar blade pressure of blade **145A** removed about 1µm of the filled paste **(115A,** leaving 1µm for layer **150B)** while P=3.5bar blade pressure of blade **145A** removed about 4µm of the filled paste **(115B,** leaving 4µm for layer **150B).** It is noted that the lower pressure of blade **145B** yields a thin and minimally-scooped layer **150B** on top of layer **150A.**

In the illustrated examples, increasing blade angle (α) of blade **145A** filling in layer 150A from α=30° to α=120° (under blade pressure of P=2.5bar, while keeping the blade pressure of blade **145B** filling in layer **150B** at 2bar and its angle at α=30°) reduced the thickness of layer **150A,** leaving more volume to form thicker top layer **150B** (illustrated schematically as filled trenches **115A** and **115B** for lower and higher blade angles, respectively). Correspondingly, in deposited features layer bottom **160B** became thicker and top layer **160A** became thinner as the filling blade angle was increased. The reduction in thickness of layer **150A** with increased blade angle was found to result from enhanced scooping with higher blade angles, e.g., using Heraeus^{™} 9651B paste, α=30° blade angle of blade **145A** removed about 1µm of the filled paste **(115A,** leaving 1µm for layer **150B)** while α=120° blade angle of blade **145A** removed about 4µm of the filled paste **(115B,** leaving 4µm for layer **150B).** It is noted that the lower angle of blade **145B** yields a thin and minimally-scooped layer **150B** on top of layer **150A.**

In the illustrated examples, increasing blade velocity (V) of blade **145A** filling in layer **150A** from V=25mm/sec to V=100mm/sec (under blade pressure of P=2.5bar and blades' angle of α=30° while keeping the blade pressure of blade **145B** filling in layer **150B** at 2bar) reduced the thickness of layer **150A,** leaving more volume to form thicker top layer **150B** (illustrated schematically as filled trenches **115A** and **115B** for lower and higher blade velocity, respectively). Correspondingly, in deposited features layer bottom **160B** became thicker and top layer **160A** became thinner as the filling blade velocity was increased. The reduction in thickness of layer **150A** with increased blade velocity was found to result from enhanced scooping with higher blade velocities, e.g., using Heraeus^{™} 9651B paste, V=25mm/sec blade velocity of blade **145A** removed practically none of the filled paste **(115A,** leaving a minimal volume for layer **150B)** while V=100mm/sec blade velocity of blade **145A** removed 3-4µm of the filled paste **(115B,** leaving 3-4µm for layer **150B).** It is noted that the lower velocity of blade **145B** yields a thin and minimally-scooped layer **150B** on top of layer **150A.** Intermediate values of the blade velocity yield intermediate values of the scooping.

In the illustrated examples, increasing blade material flexibility (M) of blade **145A** filling in layer **150A** from standard metal (e.g., stainless steel) blades **145A** over plastic (e.g., polyester or ultra-high molecular weight polyethylene - UHMWPE) blades **145A** to rubber blades **145A** (under the same blade pressure, blade angle and blade velocity) reduced the thickness of layer **150A,** leaving more volume to form thicker top layer **150B** (illustrated schematically as filled trenches **115A** and **115B** for medium and high blade flexibility, respectively). Correspondingly, in deposited features layer bottom **160B** became thicker and top layer **160A** became thinner as the filling blade flexibility was increased. The reduction in thickness of layer **150A** with increased blade flexibility was found to result from enhanced scooping with higher blade flexibility, e.g., using Heraeus^{™} 9651B paste, metal blade **145A** removed practically none of the filled paste **(115A,** leaving a minimal volume for layer **150B),** plastic blade **145A** removed 3-4µm of the filled paste **(115B,** leaving 3-4µm for layer **150B)** and rubber blade **145A** removed 6-8µm of the filled paste (filled trench **115C,** leaving 6-8µm for layer **150B).** It is noted that the lower flexibility of blade **145B** yields a thin and minimally-scooped layer **150B** on top of layer **150A.**

It is noted that specific combinations of any of the disclosed parameters and specific parameter values may be selected with respect to requirements related to the specific pastes used and pre-defined layer structure of stacks **150.** The parameters and their values may be optimized in pre-production steps of the respective process development.

In contrast to current screen-printing methods, the disclosed methods and systems are used to print ultra-fine metal paste lines on silicon wafers in PV cells, printed electronics, VLSI (very large-scale integration) packaging, etc. - utilizing the advantages of PTP methods of non-contact two process steps printing which separates paste filling stage **140** from pattern transfer stage **250**. Multi-layered fingers as elements **160** enable printing multi-material elements **160.** Advantageously, in disclosed methods and systems all the layers are formed within the same trenches so they are self-aligned; and as both steps of filling and printing are carried out in the same PTP system with the same cycle time as in case of single layer printing - disclosed printing of multi-layered features becomes cost-effective and enables a very high throughput.

For example, disclosed methods and systems may be used to print silver stack fingers 160 for PV cells, which enable further reduction of feature width (e.g., to reduce shading losses of the PV cells) while maintaining or even improving conductivity, e.g., (i) not increasing or even decreasing contact resistance (to the silicon substrate) by using bottom layer **160B** made of a paste composition that is optimized for forming the best electrical contact and good adhesion to silicon substrate (e.g., through the silicon nitride layer in TOPCon (tunnel oxide passivated contact or varieties thereof), PERC, (passivated emitter rear contact) etc. PV cells), e.g., by increased concentration of glass frits and/or (ii) not increasing or even decreasing linear resistance (along the finger length) by using top layer **160A** made of a paste composition that is optimized for conductivity along the finger, irrespective of the prior art constraint of having to maintain low surface resistance. Hence, printing elements **160** with one material **160B** interfacing substrate **70** and optimized therefor, and with another material **160A** providing the design's structural and electrical requirements and optimized therefor - enables further narrowing of the printed features while possibly even enhancing their performance such as cell efficiency.

In another example, disclosed methods and systems may be used to print self-aligned selective emitter (SE) lines, which is presently a major challenge of the PV industry. Specifically, as currently SE lines in silicon substrate are created in a separate process, before the finger metallization, accurate alignment between the printed fingers and the SE lines is required. Current solutions involve printing much wider SE lines (e.g., 100µm wide) to be covered by much narrower metal fingers (e.g., 30µm wide) - resulting in additional losses of efficiency in short wavelength spectral range. In contrast, disclosed methods and systems may be used to print SE lines by using bottom layer **160B** that includes the impurities needed for forming the SE lines and using top layer **160A** made of the paste composition that is required for finger metallization - making the present two-step printing process into a one-step printing process and providing the narrowest possible SE lines that exactly fit the metal fingers on top of the SE lines. Consecutively, during the firing process (high temperature heat treatment), all three of the SE lines, the contact to the SE lines and the metal fingers (undergoing silver sintering) are created simultaneously. This application may be applicable, e.g., for PV cells having front metallization over silicon nitride layer, such as TOPCon, PERC and the like Feasibility of such process was reported in the prior art (e.g., Rohatgi *et al.* 2001, Self-aligned self-doping selective emitter for screen printed silicon solar cells, presented at the 17th European Photovoltaic Solar Energy Conference and Exhibition; Munich, Germany; October 22-26, 2001), however screen printing does not enable forming multi-layer features in one printing process.

In yet another example, disclosed methods and systems may be used to print copper metal fingers instead of silver metal fingers, e.g., for PV cells. While copper is basically preferable to silver as metal finger material due to cost and availability considerations, currently using copper requires forming a barrier and/or seed layer (e.g., using a costly sputtering process) below the copper (e.g., using an electroplating process) to avoid diffusion of copper atoms into silicon substrate **70** - resulting in an expensive and complex production process. In contrast, disclosed methods and systems may be used to print bottom layer **160B** made of a paste composition for providing a barrier layer (e.g., made of any of silver, nickel, titanium, tantalum, etc., combinations and/or alloys thereof) and top layer **160A** made of a copper paste composition. Hence, printing elements **160** with very thin barrier layer **160B** interfacing substrate **70** and relatively thick copper layer **160A** enables using copper fingers in a single printing step - providing significant improvement over the prior art practices. In certain embodiments, layer **160B** may comprise a seed layer, used e.g., for electro-plating of a main conductive layer, e.g., made of copper. In certain embodiments, as illustrated e.g., in **Figure 2B****,** multilayer stack **150** may comprise barrier layer **150C** (contacting substrate **70** as layer **160C** of deposited line **160),** seed layer **150B** (deposited as layer **160B** on top of layer **160C)** and main conductive layer **150A** on top thereof (deposited as layer **160A** on top of layer **160B)-** forming corresponding line **160** on receiving substrate **70**.

**Figure 2B** schematically illustrates multi-layered stacks **150** with more than two layers - for printing multi-layered features **160** with more than two layers. The thickness of each layer **150A, 150B, 150C** (in the non-limiting case of three layers) may be controlled by any of the pressure apply by blades **145,** the angle of blades **145,** the velocity of blades **145** and/or the material blades **145** are made of. Specifically, the thickness of each applied layer (e.g., H1 for layer **150A** and H3 for layer **150B)** decreases with higher blade pressure, with larger blade angle, with higher blade velocity and with softer blade material - leaving more volume to be filled by consecutive layer **150B** over layer **150A** (denoted schematically H2) and by consecutive layer **150C** over layer **150B** (denoted schematically H4). As illustrated schematically in **Figures 1** and **2A****,** the transfer of multi-layered stack lines **150** onto substrate **70** is carried out by illumination applied to the back of sheet **100,** placed directly above and in close proximity to substrate **70**.

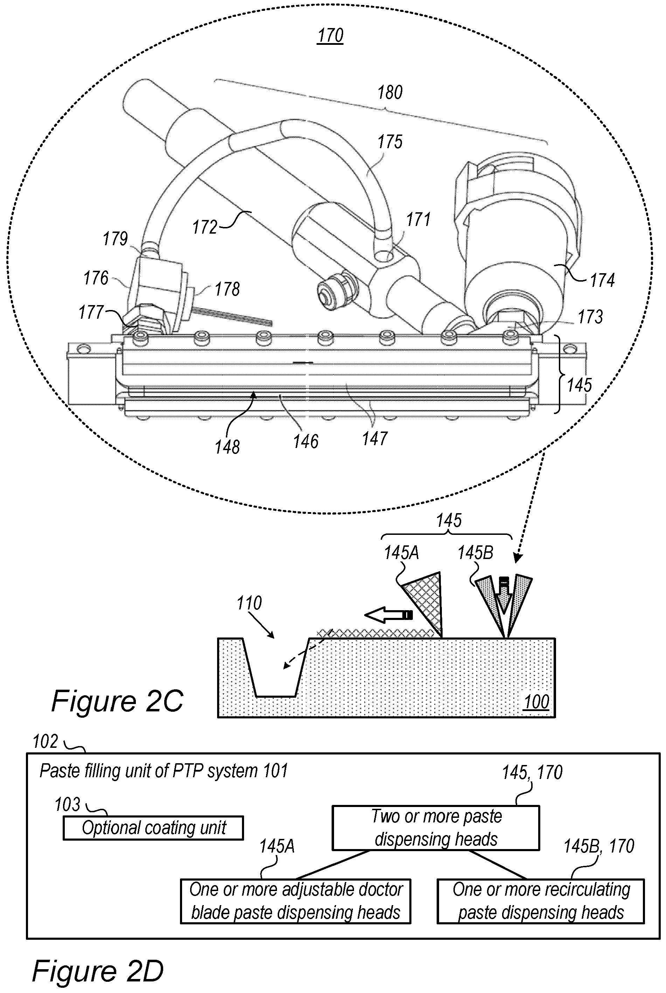

**Figure 2C** is a high-level schematic illustration of a combination of paste filling heads **145** including doctor blade dispensing **145A** and recirculating paste dispensing **145B,** according to some embodiments of the invention. The example is schematic, and various combinations of one or more doctor blade dispensing heads **145A** and/or recirculating paste dispensing heads **145B** may be used to fill the paste layers **150A, 150B,** etc. into trenches **110.** For example, recirculating paste dispensing heads **145B** may be used to fill the top paste layer, without scooping.

Paste dispensing apparatus **170** comprises a printing head **145** comprising at least two feeding openings (at the regions of junctions **177, 173),** an internal cavity **148** and at least one dispensing opening **146** that are in fluid communication (see, e.g., Chinese Patent Applications Nos. 202110673006.5 and 202121350578.1) and a pressurized paste supply unit **180** configured to circulate paste through printing head **145.** The pressure in the pressurized paste supply unit **180** may be adjusted to maintain continuous circulation of the paste through the feeding openings and internal cavity **148,** and to control dispensing of the paste through dispensing opening(s) **146.** For example, pressurized paste supply unit **180** may comprise a pressurized paste reservoir **174** and a paste pump **172** in fluid communication with internal cavity **148** of printing head **145,** which are configurated to circulate the paste therethrough. In non-limiting examples, paste pump **172** may comprise rotating pressure-tight displacement systems with self-sealing, rotor/stator designs for dispensing precise volumes such as eco-PEN450^{™} from Dymax^{™}.

It is noted that printing heads **145** may comprise one or more doctor blade dispensing head(s) **145A** and/or one or more recirculating paste dispensing head(s) **145B.** For example, one, two or more of printing heads **145A, 145B, 145C** (see, e.g., **Figures 1****,** **2A****,** **2B****)** may comprise recirculating paste dispensing head(s) such as paste dispensing apparatus **170** illustrated schematically in **Figure 2C****.** Alternatively or complementarily, one, two or more of printing heads **145A, 145B, 145C** may comprise doctor blade dispensing head(s) or other types of dispensing heads.

In various embodiments, paste dispensing apparatus **170** comprises at least one pressure sensor **178** configured to measure the pressure of the circulating paste, at one or more positions in pressurized paste supply unit **180.** Paste dispensing apparatus **170** may further comprise at least one controller (not shown) configured to adjust the pressure in pressurized paste supply unit **180** (or its components) with respect to the measured pressure of the circulating paste. Paste dispensing apparatus **170** may further comprise one or more paste mixer(s) **176** configured to mix the circulating paste. For example, paste mixer(s) **176** may be a static mixer, mixing the paste by utilizing its pressurization. In non-limiting examples, paste mixer(s) **176** may comprise plastic disposable static mixers such as GXF-10-2-ME^{™} from Stamixco^{™} made of large diameter plastic housing that includes multiple mixing elements.

Pressurized paste supply unit **180** may be further configured to introduce the paste into internal cavity **148** via at least one entry opening and to receive the circulated paste via at least one exit opening in printing head **145.** Typically, the entry opening(s) and the exit opening(s) are at the top of printing head **145,** opposite to dispensing opening(s) **146** which faces the substrate onto which the paste is deposited. Alternatively or complementarily, the entry opening(s) and/or the exit opening(s) may be positioned on sides and/or extension(s) of printing head **145.**

Pressurized paste supply unit **180** may comprise pressure-controlled paste reservoir **174,** paste pump **172** and mixer **176** that are in fluid communication. Pressure-controlled paste reservoir **174** may be configured to deliver paste to paste pump **172,** which may be configured to deliver the paste through mixer **176** to the entry opening(s). Pressurized paste supply unit **180** may be further configured to mix paste from the exit opening(s) with the paste delivered from pressure-controlled paste reservoir **174** to paste pump **172.** The exit of the pressure-controlled paste reservoir **174** is in fluid communication with the entry of the paste pump **172.** For example, paste in paste reservoir **174** may be delivered to paste pump **172,** mixing with paste exiting from the exit opening(s) of printing head **145,** to be pumped by paste pump **172** into mixer **176.** Paste from mixer **176** may be delivered to the entry opening(s) of printing head **145,** wherein the paste moves along internal cavity **148** and some paste may be dispensed through dispensing opening(s) **146** to fill trenches **110.** The remaining paste may then be mixed with paste from paste reservoir **174** (e.g., delivered through nozzle(s) at junction **173)** to compensate for the dispensed amount, and the paste is circulated through paste dispensing apparatus **170** to maintain its mechanical characteristics and support continued mixing of the paste to maintain its chemical composition. In certain embodiments, paste dispensing apparatus **170** may be further configured to modify paste composition, e.g., by adding additives such as solvents to keep the paste homogenized, possibly in relation to the monitored pressures throughout paste dispensing apparatus **170.** For example, additives such as solvents may be added to the paste entering mixer **176** if needed.

In various embodiments, pressure-controlled paste reservoir **174** and paste pump **172** may open adjacently to the exit opening(s) of printing head **145** and paste dispensing apparatus **170** may comprise a conduit **175** connecting the exit of mixer **176** to the entry opening(s) of printing head **145.** In some embodiments, pressure-controlled paste reservoir **174** and paste pump **172** may open adjacently to the exit opening(s) of printing head **145,** mixer **176** may be adjacent to the entry opening(s) of printing head **145,** and conduit **175** may connect paste pump **172** to mixer **176.** The dimensions and orientations of paste reservoir **174** and paste pump **172** may vary, e.g., both paste reservoir **174** and paste pump **172** may be set perpendicularly to printing head **145,** or one or both of paste reservoir **174** and paste pump **172** may be set at an angle to printing head **145.** For example, paste pump **172** may be set obliquely to spread its weight more evenly over printing head **145.** In various embodiments, conduit **175** may be adjusted to conform to any arrangement of paste reservoir **174,** paste pump **172** and mixer **176,** so as to make paste dispensing apparatus **170** more compact or adjust it to a given space and weight distribution requirements within the printing machine.

In various embodiments, printing head **145,** internal cavity **148** and dispensing slit **146** limited by slit edges **147** (e.g., metallic slit lips **147)** may be elongated and configured with respect to paste properties (e.g., viscosity values), specified throughput and specified features (e.g., length, width and optionally cross section) of the lines or other elements that are to be dispensed by printing head **145.** In certain embodiments, dispensing opening **146** may comprise one or more slits, one or more opening, a plurality of linearly-arranged openings, e.g., one or more lines of circular or elliptical openings, and so forth.

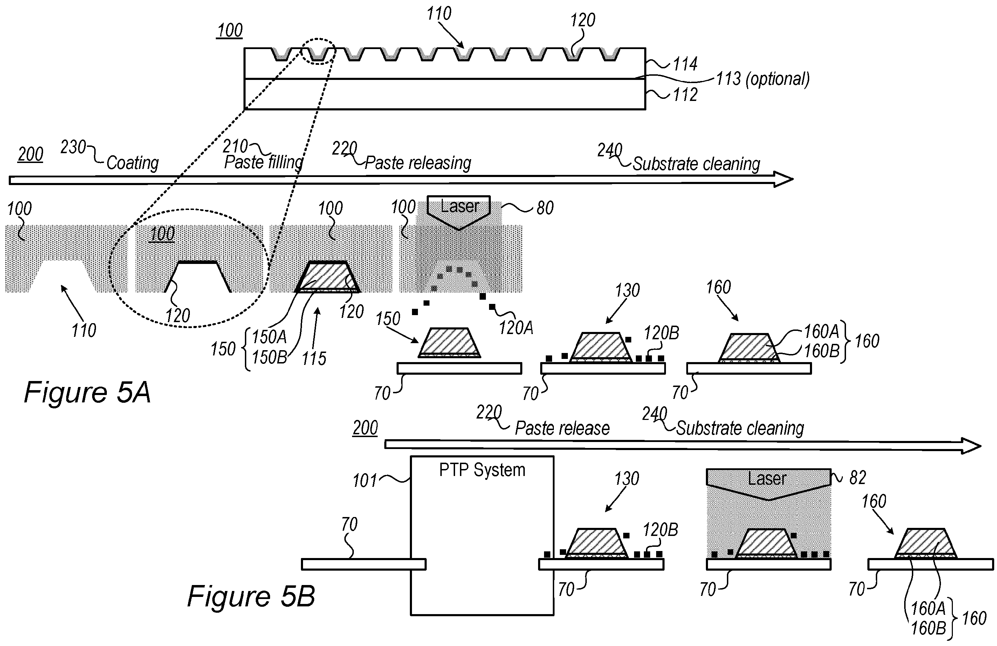

**Figure 2D** is a high-level schematic illustration of a combination of a paste filling unit **102** in a pattern transfer printing (PTP) system **101** (see also **Figure 5B****),** according to some embodiments of the invention. Paste filling unit **102** is configured to fill patterned trenches **110** on delivered pattern transfer sheets **100** with conductive printing paste, utilizing two or more paste dispensing heads **145** which are applied consecutively to fill trenches **110** with stack **150** made of layers **150A, 150B,** etc., that is transferred as stack line **150** by PTP system **101** onto receiving substrate **70** using the single illumination step to form multi-layered feature **160** as described herein.

Two or more paste dispensing heads **145** may comprise respective blades **145A, 145B,** etc., one for filling each of layers **150A, 150B,** etc., with at least one of paste dispensing heads **145** being adjustable with respect to the pressure, the blade angle, the blade velocity and/or the blade flexibility as described herein - to adjust the thickness of the respective layers. At least one of paste dispensing heads **145** may be a recirculating paste dispensing head such as paste dispensing apparatus **170** with pressurized paste supply unit **180,** used, e.g., to fill the top layer of stack **150.** Paste filling unit **102** may further comprise a coating unit **103** (illustrated schematically, see Chinese Patent Application No. 202111233805.7 for more details) configured to coat trenches **110** with a releasing layer (see **Figures 5A, 5B****)** before filling the multi-layered printing paste into trenches **110.**

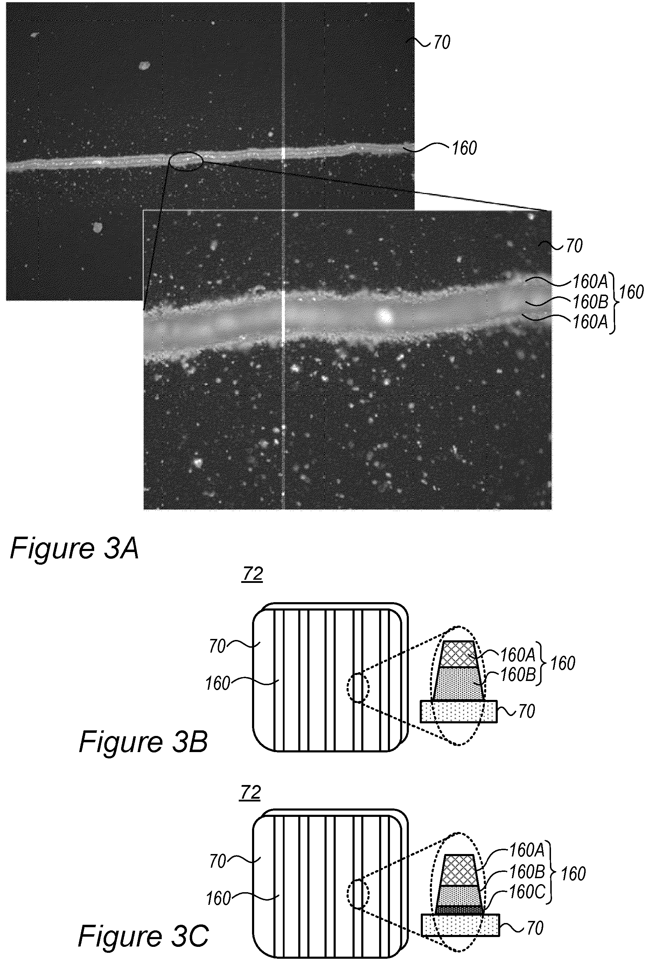

**Figure 3A** provides an example for multi-layered element **160** produced by disclosed methods and systems, according to some embodiments of the invention. The illustrated example shows a feature made of 12µm copper paste **160A** on top of 2µm silver paste **160B** (the image is focused on the Ag/Cu boundary to emphasize its multi-layered structure). The feature was prepared by first filling into trench **110** copper paste **a**s material **150A** using blade **145A** at α=30° and P=2.5bar and consecutively filling silver paste as material **150B** using blade **145B** at α=30° and P=2bar - and transferring the multi-layered paste from filled trench **115** onto substrate **70** (a silicon wafer) to yield the depicted line.

**Figures 3B** and **3C** are high-level schematic illustrations of photovoltaic solar cells **72** with multilayered conducting lines **160,** according to some embodiments of the invention. In various embodiments, solar cells **72** may comprise multilayered conducting lines **160** produced in a single transfer (illumination) step by pattern transfer method disclosed herein, e.g., using disclsoed pattern transfer sheets **100.** For example, one or more multilayered conducting lines **160** may be used in photovoltaic solar cells **72** conductive line(s) used to deliver electricity produced by photovoltaic solar cells **72** by conversion of light, e.g., with receiving substrate **70** comprising any type of light-converting material such as semiconducting material (e.g., various types of mono- or poly- crystalline silicon, various thin film materials, configured as single or multi junction cells) or used in any other photovoltaic technology that utilizes conducting lines.

Multilayered conducting lines **160** may comprise at least two layers **160A, 160B, 160C** etc. made of different materials that are transferred as multilayered stack line **150** comprising at least two different types of metal paste **150A, 150B, 150C** etc., not respectively, as disclosed herein. Following the single-step transfer, multilayered conducting lines **160** may be processed thermally according to the type(s) of paste used (e.g., fired, cured, sintered, annealed together, etc.) to form the finished lines. As non-limiting examples, silver pastes may be sintered (e.g., dried, heated up to about 800°C and thereby thermally processed, typically over tens of seconds), silver-epoxy pastes may be cured (e.g., heated up to 200°-300°C and thereby thermally cross-linked, typically over tens of minutes), copper nano-particle pastes may be sintered at relatively low temperature, and so forth. The specific parameters of the thermal processing of transferred multilayered stacks B into multilayered conducting lines **160,** such as temperature profile, duration and the gas atmosphere may be adjusted with respect to the metal paste components in the stack.

Multilayered conducting lines **160** may comprise at least two layers **160A, 160B, 160C** etc. made of different materials that are transferred as multilayered stack line **150** comprising at least two different types of metal paste **150A, 150B, 150C** etc., not respectively, as disclosed herein. Following the single-step transfer, multilayered conducting lines **160** may be processed thermally with the respect to the type(s) of paste used (e.g., fired, cured, annealed together, etc.) to form the finished lines. As non-limiting examples, silver pastes may be sintered (e.g., dried, heated up to 800°C and thereby thermally processed, typically over tens of seconds), silver-epoxy pastes may be cured (e.g., heated up to 200°-300°C and thereby thermally processed, typically over tens of minutes), copper nano-particle pastes may be annealing at low temperature, and so forth. The specific parameters of the thermal processing of transferred multilayered stacks B into multilayered conducting lines **160,** such as temperature profile, duration and the gas atmosphere may be adjusted with respect to the metal paste components in the stack.

In certain embodiments, multilayered conducting line(s) **160** may comprise bottom layer (e.g., denoted **160B in** **Figure 3B****, 160C in** **Figure 3C****)** comprising a material configured to bind (mechanically and/or electrically) transferred stack line **160** to receiving substrate **70**, and at least one top layer (e.g., denoted **160A in** **Figure 3B****, 160A, 160B in** **Figure 3C****)** comprising a material configured to provide conductivity along transferred stack line **160.** For example, the bottom layer may comprise a paste composition that is optimized for forming the best electrical contact and to provide good adhesion to silicon substrate, e.g., having increased concentration of glass frits and/or optionally decreased linear resistance (along the finger length), which is compensated for by the higher linear conductivity of the top layer.

In certain embodiments, multilayered conducting line(s) **160** may comprise bottom layer (e.g., denoted **160B** in **Figure 3B****, 160C** in **Figure 3C****)** comprising a material configured to form selective emitter (SE) lines **160** on receiving substrate **70**, and at least one top layer (e.g., denoted **160A** in **Figure 3B****, 160A, 160B** in **Figure 3C****)** comprising a material configured to provide conductivity along transferred stack line **160** and electrical contact to receiving substrate **70**. For example, the bottom layer may comprise a paste composition that provides the impurities needed for forming the SE lines and compensating for possible reduced conductivity thereof by the higher linear conductivity of the top layer - allowing the production of much thinner SE lines as they are transferred using a single PTP step.

In certain embodiments, multilayered conducting line(s) **160** may comprise bottom layer (e.g., denoted **160B** in **Figure 3B****, 160C** and optionally **160B** in **Figure 3C****)** comprising a material configured to provide a barrier and/or seed layer upon receiving substrate **70**, and at least one top layer (e.g., denoted **160A** in **Figure 3B****, 160A** in **Figure 3C****)** comprising a material configured to provide conductivity along transferred stack line **160.** For example, the bottom layer may comprise paste of, e.g., silver, nickel, titanium, tantalum, etc., combinations and/or alloys thereof) as a barrier/seed layer, with the top layer comprising a copper paste that provides high linear conductivity at reduced material costs. Barrier/seed layer(s) may comprise one, two or more layers, as illustrated e.g., schematically in **Figure 3C** (with top layer **160A** comprising copper).

In various embodiments, photovoltaic solar cells **72** may comprise combinations of multilayered conducting lines **160** disclosed herein.

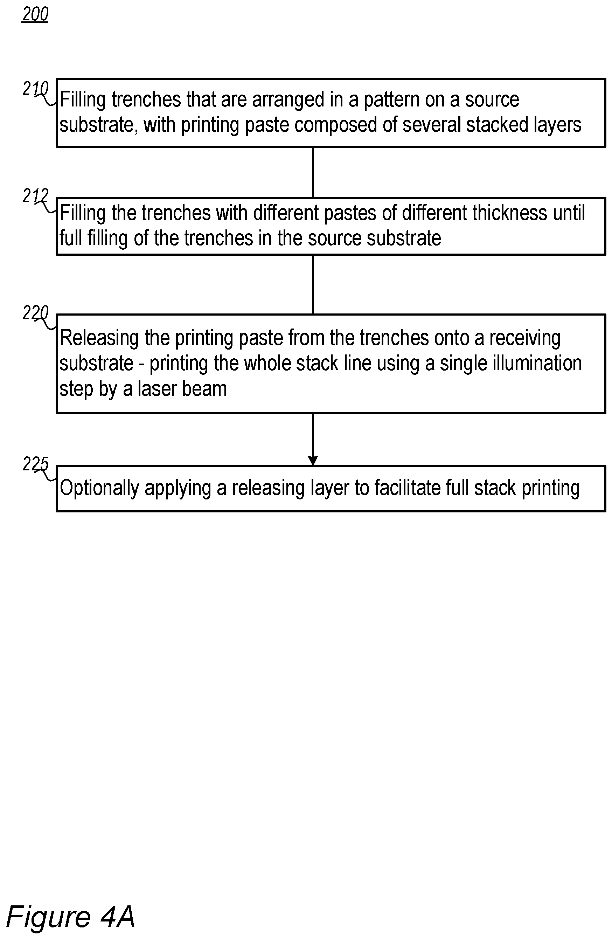

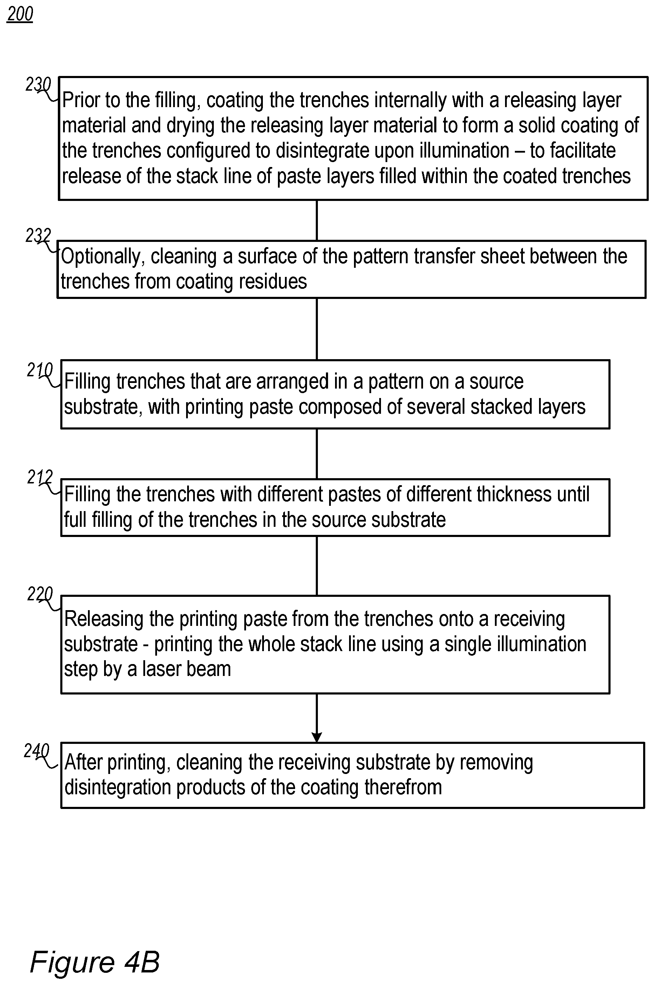

**Figures 4A** and **4B** are high-level flowchart illustrating pattern transfer methods **200**, according to some embodiments of the invention. The method stages may be carried out using pattern transfer sheet(s) **100** and/or with respect to corresponding PTP systems, which may optionally be configured to implement method **200**.

Method **200** comprises filling with printing paste a plurality of trenches that are arranged in a pattern on a source substrate (stage **210),** wherein the printing paste comprises a stacked plurality of layers and the filling is carried out layer-by-layer, and releasing the printing paste from the trenches onto a receiving substrate through illumination by a laser beam- transferring the whole stack line of multi-layered printing paste onto the receiving substrate using a single illumination step (stage **220**).

Filling **210** may be carried out by filling the trenches with different pastes of different thickness until full filling of the trenches in the source substrate (stage **212).** For example, filling **210** may be carried out by a plurality of blades, one for each layer, and the pattern transfer method further comprising adjusting a thickness of at least one of the layers by adjusting at least one of: a pressure applied to the respective blade, a blade angle of the respective blade, a blade velocity of the respective blade, and/or a flexibility of the respective blade. For example, the pressure may be selected within 2-4bar, the blade angle may be selected within 30°-120°, the blade velocity may be selected within 25-100mm/sec and/or a blade material is selected from stainless steel, plastic and rubber.

In some embodiments, at least two of the layers comprise different material compositions and/or different materials, e.g., selected from: (i) a bottom layer comprising a material configured to bind, mechanically and/or electrically, the transferred stack line to the receiving substrate and at least one top layer comprising a material configured to provide conductivity along the transferred stack line, (ii) a bottom layer comprising a material configured to form selective emitter (SE) lines on the receiving substrate, and at least one top layer to provide conductivity along the transferred stack line and electrical contact to the receiving substrate, and/or (iii) a bottom layer comprising a material configured to provide a barrier and/or seed layer upon the receiving substrate and at least one top layer comprising a material configured to provide conductivity along the transferred stack line. In certain embodiments, the bottom layer may comprise a releasing material composition, e.g., as disclosed below.

Method **200** may further optionally comprise applying a releasing layer to facilitate full stack printing (stage **225),** illustrated in more detail in **Figure 4B** and comprising, for example, (i) prior to the filling, coating the trenches internally with a releasing layer material and drying the releasing layer material to form a solid coating of the trenches configured to disintegrate upon illumination - to facilitate release of the stack line of paste layers filled within the coated trenches (stage **230),** optionally, cleaning a surface of the pattern transfer sheet between the trenches from coating residues (stage **232);** and (ii) after printing, cleaning the receiving substrate by removing disintegration products of the coating therefrom (stage **240**).

Advantageously, disclosed methods and systems, based on non-contact paste transfer, enable printing multi-layered elements, in contrast e.g., to prior art methods such as screen printing (SP) which is a cost-effective production method for printing single layers of high viscosity pastes on different substrates by paste filling of the screen and printing features on a receiving substrate carried out simultaneously. However, as screen printing is a contact technology, printing multi-layered features requires to transfer a substrate with the first (still wet) layer to a dryer and then to the same or another printer with an additional alignment of the second layer to the previous layer. The accuracy of such alignment is limited (mainly because two different screens are not identical and deviate differently with time), the process is much more costly and it is hardly possible to print very fine multi-layer features using prior art SP.

**Figures 5A** and **5B** are high-level schematic side-view illustrations of a pattern transfer process for producing multi-layered features and utilizing a releasing layer **120,** according to some embodiments of the invention. Trenches **110** in sheet **100** (as source substrate) may be coated internally by coating **120** configured to disintegrate upon illumination **80**, to enhance the releasing of multi-layered paste stack **150.** Coated trenches that are filled with multi-layered paste are denoted schematically by the numeral **115.** During the releasing of multi-layered paste stack line **150,** coating **120** may disintegrate (indicated schematically by numeral **120A)** and be deposited on wafer **70** (as receiving substrate) together with released multi-layered paste stack line **150.** As a result, wafer **70** may comprise the released multi-layered paste stack line (denoted schematically by numeral **150A)** and residues (and/or disintegration products) of coating (denoted schematically by numeral **120B)** - an intermediate state denoted by numeral **130.** Following the pattern transfer process (by PTP system **101),** coating residues **120B** may be removed from wafer **70**, e.g., by high temperature treatment (e.g., sintering or drying), which is usually applied for sintering printed metal paste in PV cells manufacturing, or by using an illumination **82** to modify and/or remove the residues - to clean the receiving substrate and yield wafer **70** with released paste and without coating disintegration products and residues. Illumination **82** may be same as, similar to or different from illumination **80**. In various embodiments, any of the following methods may be used to remove residues **120B** of the releasing material: high temperature decomposition (e.g., firing), selective laser vaporization, vacuum-assisted vaporization, air blowing and/or solvent wet washing.

Coating **120,** also termed releasing layer **120** for its function, may be a thin layer (e.g., be 1-10 µm thick) deposited on pattern transfer sheet **100** as a source substrate or at least into trenches **110** thereof. In some cases, the material(s) of releasing layer **120** (denoted - the releasing material(s)) may be mixed with any of the components of the multilayered paste prior to filling the layers into trenches **110.** Non-limiting examples for releasing materials include acetone-based ClearWeld^{™} LD920 series and acrylic resins such as Spectra 390^{™} by Epolin.

For example, coating **120** may be carried out by spreading a coating solution (for example having a solid content between 10% and 20%, or 12%, 14%, 16%, 18%) (e.g., using blade(s), rolls, dies, etc.) and drying the releasing layer to form a solid layer of the trenches, e.g., which may range in thickness between 1µm and 10µm (for example 3µm, 5µm, 7µm, 9µm). If required, the surface of pattern transfer sheet **100** between trenches **110** from coating residues, e.g., using scraping blade(s) and/or sticky rollers

Coating **120** may comprise organic materials such as NIR absorbing dyes. At least one of the materials for coating **120** is selected to absorb laser illumination **80** used in the PTP process (e.g., laser with a wavelength of 1064 nm, 1070 nm or any other wavelength in the NIR spectral range). One or more of the materials may be selected to have a maximal absorption at the illumination wavelength. The releasing material(s) may be configured to change phase, evaporate and/or be ablated upon absorption of the laser illumination energy - to yield a thrusting force that pushes multi-layered paste stack line **150** out of trenches **110** (without changing the shape of the paste) and releases multi-layered paste stack line **150** onto receiving substrate **70**. For example, for using Nd:Yag laser (1060-1085nm) for illumination **80,** coating **120** may comprise NIR (near infrared) absorbing dyes.

Coating **120** may be used to replace or augment the use of volatile components of the paste (e.g., added to evaporate upon illumination and release paste multi-layered paste stack **150).**

Advantageously, the inventors have found out that using coating **120** enables to print paste pattern on receiving substrate **70** with a much higher aspect ratio, e.g., at least 0.7 and up to 1-2 - instead of prior art 0.4-0.5; as well as to print extremely narrow fingers, down to 10µm wide - instead of prior art above 25-30µm wide - as illustrated in Chinese Patent Application No. 202111233805.7 filed on October 22, 2021. Furthermore, avoiding use of volatile compounds in components of the paste broadens the range of printable pastes and makes the process much less sensitive to drying of the paste within the PTP system. Furthermore, although releasing layer **120** is much thinner than paste, a lower laser power is required to release the paste and therefore printing can be carried out at a higher scanning beam velocity, yielding higher system throughput. Finally, using releasing layer **120** makes the printing process more accurate, avoiding printing quality defects of the printing pattern such as paste debris.

In various embodiments, as disclosed, e.g., in Chinese Patent Application No. 202111233805.7, coating **120,** functioning as the releasing layer, may be deposited or applied by any known technique, such as gravure, micro gravure, transfer roll, slot extrusion, reverse comma, Mayer rod, doctor blade or other techniques, applied by corresponding coaters. For example, using doctor blade(s), trenches **110** may be filled with a coating solution while keeping the surfaces between trenches **110** clean. After drying the coating solution, coating **120** is formed within trenches **110** at a thickness determined mainly by the solid content of the coating solution. Enclosed chamber doctor blade (protecting or enclosing the coating solution) may be configured to improve the control of the coating solution and to ensure the cleanliness of the surfaces between the trenches. In another example, the coating solution may be applied to the surface of at least a portion of pattern transfer sheet **100,** e.g., using a rod spreading technique, spraying, slot extrusion, etc., and drying to form coating **120** as well as the residues on the surfaces between trenches **110.** The residues may be removed by various methods, such as scraping blade(s) (made, e.g., of metal, plastic, rubber, etc.) set at specified angles, sticky rollers, etc. - leaving coating **120** within trenches **110.** Removed residues may be recycled. Any of the coating processes may be carried out in stationary mode (with stationary pattern transfer sheet **100** and respective coating elements moving with respect thereto) and/or in continuous mode (with stationary coating elements and pattern transfer sheet **100** moving with respect thereto, e.g., using rolls in a roll-to-roll approach). The coating processes may be carried out in advance, before feeding pattern transfer sheet **100** into PTP system **101,** or during their movement in PTP system **101,** e.g., just before paste filling of the trenches.

In various embodiments, at least the surfaces of trenches **110** may be treated to enhance or control adhesion of coating **120** thereto, using surface treatment techniques such as plasma (e.g., corona), applying silane additives, etc. Surface treatment may be configured to balance between a required coating adhesion within trenches **110,** removal of residues from the surfaces between trenches (if needed) and paste release by coating disintegration, as well as by possible sheet recycling considerations.

In various embodiments, PTP system **101** may be configured to inspect and control any of the multilayer deposition stages and/or the coating and cleaning processes, e.g., at a print quality station controlling the printing quality of the fingers, to keep the processes within predefined process windows.

In various embodiments, coating residues **120B** may be removed by any of the following procedures: high temperature decomposition, selective laser vaporization, vacuum assisted vaporization (reducing the boiling point of coating residues **120B),** air blowing and/or solvent washing. Using heat-based procedures to remove coating residues **120B,** the coating material may be selected to have decomposition and/or boiling temperatures that do not affect deposited finger **160** and receiving substrate **70**. For example, coating material may be selected to have decomposition and/or boiling temperatures that are well below the high sintering temperature of the c-Si PV metallization process (~850°C), or optionally below the curing temperature for cured pastes (e.g., silver epoxy pastes). For example, the decomposition and/or evaporation temperatures of coating residues **120B** may be in the range of 200°C - 300°C. In certain embodiments, same laser illumination **80** used to evaporate layer **120** used to release multi-layered paste stack **150** may also be used to evaporate and/or decompose coating residues **120B** on wafer **70**. It is noted that removing coating residues **120B** may be carried out in a single process stage or in two or more process stages, e.g., high temperature decomposition (e.g., by laser illumination **80** and/or in an drying oven or sintering furnace) followed by low temperature washing or blowing.

The following non-limiting examples disclose NIR absorbing dyes for use with Nd:Yag laser illumination. In addition to the NIR absorbing dyes, coating **120** may further comprise solvents, as well as optionally binders, surface agents and/or viscosity modifiers.

Non-limiting examples for components of NIR absorbing dyes include Diimonium ionic complex(es), Ditholene complex(es) and/or phthalocyanine. The illustrated Diimonium ionic complex may include, e.g., alkyl chain(s) as one or more residue(s) R and counter ions (not shown) such as *2SbF₆⁻.*

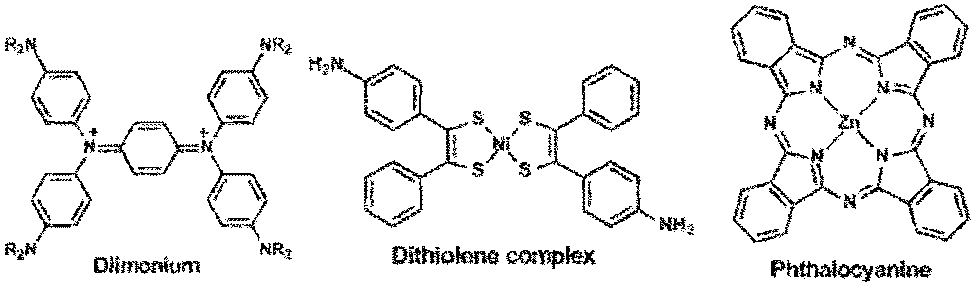

Additional, non-limiting examples for components of NIR absorbing dyes in any of the disclosed embodiments may include any of cyanine (tetramethylindo(di)-carbocyanines) dyes such as, e.g., open chain cyanines (R₂N⁺=CH[CH=CH]ₙ⁻NR₂), hemicyanines (Aryl=N⁺=CH[CH=CH]ₙ-NR₂), closed chain cyanines (Aryl=N⁺=CH[CH=CH]ₙ-N=Aryl), neutrocyanines (R2N⁺=CH[CH=CH]ₙ-CN and R₂N⁺=CH[CH=CH]ₙ-CHO), e.g., with extended [CH=CH]ₙ chains, or variants or mixtures thereof; phthalocyanine or naphthalocyanine dyes (comprising four isoindole units linked by a ring of nitrogen atoms) or metal complexes thereof (e.g., with aluminum or zinc), dithiolene metal complexes (having one to three dithiolene ligands), e.g., with nickel, squaraine dyes such as squarylium dye III, quinone analogues, diimonium compounds and azo derivatives, and/or any of their variants, derivatives and/or combinations.

Solvent(s) included in the coating formulation may be selected to dissolve the dye(s) as well as optional binder(s) and additive(s), and may comprise, e.g., acetone, ketones, alcohols, aromatic hydrocarbons and/or glycol ethers solvents.

The coating formulation may further comprise binder(s) comprising polymers and/or polymer precursors for forming coating **120** as a continuous film in trenches **110,** such as, e.g., poly-vinyl butyral, ethyl-cellulose and/or derivatives thereof, as long as the decomposition temperature of binder(s) is below the paste sintering temperature (e.g., 800°C for silver pastes, or e.g., 850°C, 800°C, 750°C, 700°C, 650°C, 600°C, 550°C, 500°C, 450°C, 400°C, 350°C for silver pastes or other metal pastes or mixtures thereof) or below the paste curing temperature (e.g., 300°C for silver epoxy pastes, or e.g., 300°C, 250°C, 200°C for silver epoxy pastes or other metal pastes). Binder(s) may further be selected to minimize the amount of coating residues **120B** and/or to simplify the removal thereof.

The coating formulation may further comprise surface wetting additive(s) selected to stabilize the dispersion of the different coating components and/or viscosity modifier(s) selected to support the application of coating **120** in trenches **110.** The additive(s) and/or viscosity modifier(s) are selected to have their decomposition temperature below the paste sintering or curing temperature (depending on the type of the paste) and may further be selected to minimize the amount of coating residues **120B** and/or to simplify the removal thereof.

In certain embodiments, the solid content of coating **120** may be between 10wt% and 20wt% to enable reaching coating **120** which is 1-10 µm thick within trenches **110** that are 20-30 µm deep.

In certain embodiments, the coating formulation or any of its components, such as the NIR absorbing dyes, may be mixed at least into layer **150A,** which as the inner (bottom) layer and commonly the thickest layer, has the largest contact area with trenches **110** of sheet **100.** Mixing releasing material into at least inner layer **150A** of multi-layered paste stack **150** may enhance releasing or possible at least partially enable replacing coating **120** (e.g., in certain regions of pattern transfer sheet **100).** For example, at least a portion of the release material may be mixed with at least inner layer **150A** of paste stack **150** (e.g., as a component of the paste that is deposited as layer **150A** or as an additive that is mixed during past deposition) to improve the releasing of multi-layered paste stack line **150.** Mixing releasing material into at least the inner (bottom) layer of paste stack **150** may yield print quality improvement. Disclosed releasing material may be added to provide a few percent of the material of the inner layer of multi-layered paste stack **150,** e.g., between 1-5% of the inner layer material. In certain embodiments, both coating **120** and the mixing of the releasing material into at least the inner layer paste may be applied.

Accordingly, at least inner layer **150A** of multi-layered paste stack **150** may comprise, in addition to commercially available printing pastes (e.g., SOL9651B^{™} from Heraeus^{™}), NIR absorbing dyes such as Diimonium ionic complex(es), Ditholene complex(es) and/or phthalocyanine as illustrated herein. It is noted that NIR absorbing dyes may be added to silver pastes, to silver epoxy pastes, or to any other material, which is used as the inner layer of the multi-layer stack within the trench.

Certain embodiments comprise a multi-layered paste stack for use in a pattern transfer process (that includes filling the paste into trenches in the pattern transfer sheet which are arranged in a specified pattern, and consecutively releasing the paste from the trenches onto the receiving substrate upon illumination by the laser beam). For example, in case the illumination is in NIR, the paste comprises a releasing material configured to enhance the releasing of the paste from the trenches, with the releasing material comprising at least one NIR absorbing dye comprising at least one of: a Diimonium ionic complex, a Ditholene complex, phthalocyanine, derivatives, salts and/or combinations thereof. Non-limiting examples include dyes from TCI (Tokyo Chemical Industry, Ltd), Epolight^{™} 1117 (Tetrakis(decyl)ammonium structure) by Epolin and/or Lunir5^{™} by Luminochem.

Disclosed sheets **100** may be used to print fine lines of thick metallic paste on silicon wafers, e.g., for photovoltaic (PV) cells as well as to produce electronic circuits by creating conductive lines or pads or other features (e.g., on laminates for PCBs) for printed passive electronic components like resistors or capacitors, or for other printed electronic devices. Other applications may comprise creating conductive features in the manufacturing processes of mobile phones antennas, decorative and functional automotive glasses, semiconductor integrated circuits (IC), semiconductor IC packaging connections, printed circuit boards (PCB), PCB components assembly, optical biological, chemical and environment sensors and detectors, radio frequency identification (RFID) antennas, organic light-emitting diode (OLED) displays (passive or active matrix), OLED illuminations sheets, printed batteries and other applications. For example, in non-limiting solar applications, the metallic paste may comprise metal powder(s), optional glass frits and modifier(s), volatile solvent(s) and non-volatile polymer(s) and/or or resin(s). A non-limiting example for the paste includes SOL9651B^{™} from Heraeus^{™}. The metal pastes may include silver, copper or other metals and/or their combinations and/or alloys. Any of the metal pastes may include any type of electrically conductive adhesive (ECA) pastes.

Filling of the paste into trenches **110** may be carried out by any type of paste-filling head operating within any type of PTP system **101.** The filling process may be controlled to assure continuous and uniform filling of the trenches and marks with paste.

In certain embodiments, pattern transfer sheet **100** may be transparent to laser beam **80** and comprise at least a top polymer layer **114** comprising trenches **110** (illustrated in **Figures 1** and **5A****)** embossed, press molded, pneumatically molded or laser molded thereon. In the illustrated non-limiting example, trenches **110** are illustrated as being trapezoid in cross section.

Periodical trenches **110** may comprise trenches, recesses and/or indentations that are embossed (e.g., press molded, pneumatically molded or laser molded) in a similar manner into top polymer layer **114,** and may have similar or different profiles. For example, trenches **110** may have various profiles (cross section shapes), such as trapezoid, rounded, square, rectangular and/or triangular profiles. In various embodiments, the pattern of trenches **110** on transfer sheet **100** may comprise continuous trenches **110** and/or arrays of separated dents. It is noted that the term "trenches" is not to be construed as limiting the shape of trenches **110** to linear elements, but is understood in a broad sense to include any shape of trenches 110, as long as the trenches have a uniform depth.

Pattern transfer sheet **100** may further comprise a bottom polymer layer **112** having a melting temperature that is higher than an embossing temperature of top polymer layer **114.** In a non-limiting example, top polymer layer **114** may have a melting temperature (Tₘ) below 170°C, below 150°C, below 130°C, below 110°C (or any intermediate range) in case it is made of semi-crystalline polymer, or a glass temperature (T_{g}) below 160°C, below 140°C, below 120°C, below 100°C (or any intermediate range) in case it is made of amorphous polymer. The melting temperature of bottom polymer layer **112** may be above the melting point of top polymer layer **114,** e.g., above 100°C (e.g., in case top polymer layer **114** is made of polycaprolactone and has Tₘ/T_{g} about 70°C), above 120°C, above 150°C, above 160°C (e.g., bi-axially-oriented polypropylene) and up to 400°C (e.g., certain polyimides), or intermediate values.

In various embodiments, polymer layers **112, 114** may be made of at least one of: polyethylene, polypropylene, polyethylene terephthalate, polybutylene terephthalate, polyethylene naphthalate, fully aromatic polyester, other copolymer polyester, polymethyl methacrylate, other copolymer acrylate, polycarbonate, polyamide, polysulfone, polyether sulfone, polyether ketone, polyamideimide, polyether imide, aromatic polyimide, alicyclic polyimide, fluorinated polyimide, cellulose acetate, cellulose nitrate, aromatic polyamide, polyvinyl chloride, polyphenol, polyarylate, polyphenylene sulfide, polyphenylene oxide, polystyrene, or combinations thereof - as long as top polymer layer **114** has a melting or glass transition temperature (Tₘ/T_{g}) below the melting or glass transition temperature (Tₘ/T_{g}) of bottom polymer layer **112** and/or as long as bottom polymer layer **112** is not affected by the processing conditions of top polymer layer **114.**

In certain embodiments, the bottom polymer layer **112** and the top polymer layer **114** may be each between 10µm and 100µm thick, e.g., between 15µm and 80µm thick, between 20µm and 60µm thick, between 25µm and 40µm thick, or within any intermediate range, with bottom polymer layer **112** being at least as thick as top polymer layer **114.** The bottom polymer layer **112** and the top polymer layer **114** may be attached by an adhesive layer **113** thinner than 10µm (e.g., thinner than 8µm, thinner than 6µm, thinner than 4µm, thinner than 2µm or having any intermediate thickness), that is transparent to laser beam **80**. For example, in certain embodiments, top polymer layer **114** may be thicker than the depth of trenches **110** by several µm, e.g., by 5µm, by 3-7µm, by 1-9µm, or by up to 10µm. For example, trenches **110** may be 20µm deep, top polymer layer **114** may be between 20-30µm thick (e.g., 25µm thick) and bottom polymer layer **112** may range in thickness between 30µm and 40µm (it is noted that thicker bottom polymer layers **112** provide better mechanical performances).

The temperature and thickness of top polymer layer **114** and bottom polymer layer **112** may be designed so that top polymer layer **114** has good molding, ductility and certain mechanical strength, while bottom polymer layer **112** has good mechanical strength. Both top polymer layer **114** and bottom polymer layer **112** may be designed to have good bonding properties.

Elements from **Figures 1-5B** may be combined in any operable combination, and the illustration of certain elements in certain figures and not in others merely serves an explanatory purpose and is non-limiting. It is noted that disclosed values may be modified by at least ±10% of the respective values.

Advantageously, while the prior art cannot achieve a printed pattern with features comprising multiple conductive layers, disclosed embodiments meet the performance and production challenges of paste fingers for electronic circuits using a single-stage multi-layered stack printing, which enables to combine different materials within the stack, separating the substrate compatibility requirement and the finger performance requirement from each other, and inherently ensuring alignment between the layers.

**In** the above description, an embodiment is an example or implementation of the invention. The various appearances of "one embodiment", "an embodiment", "certain embodiments" or "some embodiments" do not necessarily all refer to the same embodiments. Although various features of the invention may be described in the context of a single embodiment, the features may also be provided separately or in any suitable combination. Conversely, although the invention may be described herein in the context of separate embodiments for clarity, the invention may also be implemented in a single embodiment. Certain embodiments of the invention may include features from different embodiments disclosed above, and certain embodiments may incorporate elements from other embodiments disclosed above. The disclosure of elements of the invention in the context of a specific embodiment is not to be taken as limiting their use in the specific embodiment alone. Furthermore, it is to be understood that the invention can be carried out or practiced in various ways and that the invention can be implemented in certain embodiments other than the ones outlined in the description above.

The invention is not limited to those diagrams or to the corresponding descriptions. For example, flow need not move through each illustrated box or state, or in exactly the same order as illustrated and described. Meanings of technical and scientific terms used herein are to be commonly understood as by one of ordinary skill in the art to which the invention belongs, unless otherwise defined. While the invention has been described with respect to a limited number of embodiments, these should not be construed as limitations on the scope of the invention, but rather as exemplifications of some of the preferred embodiments. Other possible variations, modifications, and applications are also within the scope of the invention. Accordingly, the scope of the invention should not be limited by what has thus far been described, but by the appended claims only.

## Claims

1. A pattern transfer sheet (100) comprising:
a plurality of trenches (110) in a polymer film (114), wherein the trenches are arranged in a pattern, have a uniform depth and are filled with printing paste,
wherein the trenches in the pattern transfer sheet are configured to facilitate releasing of the printing paste from the trenches onto a receiving substrate upon illumination of the pattern transfer sheet by a laser beam (80), and
wherein the printing paste comprises a stack (150) made of a plurality of layers (150A, 150B), that is to be transferred as a single stack line (160) that includes the plurality of layers (160A, 160B) onto the receiving substrate (70) using a single illumination by the laser beam.

2. The pattern transfer sheet of claim 1, wherein at least two of the paste layers comprise different conductive material compositions and/or different materials.

3. The pattern transfer sheet of claim 2, wherein the at least two of the layers comprise:
a bottom paste layer (160B) that comprises a material selected to bind, mechanically and/or electrically, the transferred stack line to the receiving substrate, wherein the bottom layer material is optionally selected to form selective emitter, SE, lines on the receiving substrate and/or to provide a barrier and/or a seed layer upon the receiving substrate, and optionally comprises at least one of: silver, nickel, titanium, tantalum, alloys and/or combinations thereof; and
at least one top paste layer (160A) that comprises a material selected to provide conductivity along the transferred stack line, wherein the material of the at least one top layer is optionally selected to provide conductivity along the transferred stack line and/or electrical contact to the receiving substrate, and optionally comprises silver paste and/or copper.

4. The pattern transfer sheet of claim 3, wherein a thickness of the bottom layer is between 1-5µm or between 1-2µm.

5. The pattern transfer sheet of claim 3 or 4, wherein the bottom layer comprises a material composition selected to enhance the releasing of the multi-layered paste stack.

6. The pattern transfer sheet of any of claims 1-5, wherein the trenches are coated internally by a coating configured to disintegrate upon the illumination applied for the paste release, to enhance the releasing of the multi-layered paste stack.

7. The pattern transfer sheet of any one of claims 1-6, wherein the pattern transfer sheet is transparent to the laser illumination, the trenches have a cross section of any of trapezoid, rectangular, rounded or triangular, and the trenches are formed into the pattern transfer sheet by press molding, pneumatic molding, laser molding or embossing.

8. The pattern transfer sheet of claim 7, wherein the pattern transfer sheet comprises at least one polymer layer (112, 114)
which is made of at least one of: polyethylene, polypropylene, polyethylene terephthalate, polybutylene terephthalate, polyethylene naphthalate, fully aromatic polyester, aromatic-aliphatic copolyester, copolymer acrylate, polycarbonate, polyamide, polysulfone, polyether sulfone, polyether ketone, polyamideimide, polyether imide, aromatic polyimide, alicyclic polyimide, fluorinated polyimide, cellulose acetate, cellulose nitrate, aromatic polyamide, polyvinyl chloride, polyphenol, polyarylate, polyphenylene sulfide, polyphenylene oxide, or polystyrene.

9. A pattern transfer method (200) comprising:
filling (210), layer-by-layer, a stack (150) line made of a plurality of printing paste layers (150A, 150B) into a plurality of trenches (110) on a source substrate (100), wherein the trenches are arranged in a pattern and have a uniform depth, and
releasing (220), using a single illumination step, the stack line from the trenches onto a receiving substrate (70) through illumination by a laser beam (80).

10. The pattern transfer method of claim 9, wherein the filling is carried out by a plurality of blades (145), one for each printing paste layer, and the pattern transfer method further comprising
adjusting a thickness of at least one of the printing paste layers by adjusting at least one of: a pressure
applied to the respective blade, a blade angle of the respective blade, a blade velocity of the respective blade, and/or a flexibility of the respective blade.

11. The pattern transfer method of claim 10,
wherein the pressure is selected within 2-4bar, the blade angle is selected within 30°-120°, the blade velocity is selected within 25-100mm/sec and/or a blade material is selected from stainless steel, plastic and rubber.

12. The pattern transfer method of any one of claims 9-11, wherein at least two of the printing paste layers
on the receiving substrate comprise different materials, which are selected from:
a bottom layer (160B) comprising a material configured to bind the transferred stack line (160) to the receiving substrate and at least one top layer (160A) comprising a material configured to provide conductivity along the transferred stack line,
a bottom layer comprising a material configured to form selective emitter, SE, lines on the receiving substrate, and at least one top layer configured to provide conductivity along the transferred stack line and electrical contact to the receiving substrate, and/or
a bottom layer comprising a material configured to provide a barrier and/or seed layer upon the receiving substrate and at least one top layer comprising a material configured to provide conductivity along the transferred stack line, wherein, optionally the bottom layer comprises a releasing material composition.

13. The pattern transfer method of any of claims 9-12, further comprising:
prior to the filling, coating (230) the trenches internally with a coating (120) configured to disintegrate upon the illumination, to enhance the releasing of the stack, and optionally after the releasing, cleaning (240)
the receiving substrate by removing disintegration products of the coating therefrom.

14. The pattern transfer method of claim 13, wherein the coating is carried out by at least one of:
spreading a coating solution having a solid content between 10% and 20% and drying thereof, and
at least one of: gravure, micro gravure, transfer roll, slot extrusion, reverse comma, Mayer rod and/or doctor blade,
wherein, optionally, the cleaning is carried out by at least one of: high temperature decomposition, optionally by an illumination same as the illumination used to release the stack, selective laser vaporization, vacuum assisted vaporization, air blowing and/or solvent washing.

15. A photovoltaic solar cell (72) comprising the receiving substrate (70) with at least one of the multi-layer stack lines (160)
transferred thereto by the pattern transfer method of any one of claims 9-14, wherein the at least one multi-layer stack line includes the plurality of printing paste layers (160A, 160B).

## Patentansprüche

1. Musterübertragungsblatt (100), umfassend:
eine Vielzahl von Gräben (110) in einem Polymerfilm (114),
wobei die Gräben in einem Muster angeordnet sind, eine einheitliche Tiefe aufweisen und mit Druckpaste gefüllt sind,
wobei die Gräben in dem Musterübertragungsblatt dazu konfiguriert sind, die Abgabe der Druckpaste aus den Gräben auf ein Empfangssubstrat bei Beleuchtung des Musterübertragungsblatts mit einem Laserstrahl (80) zu erleichtern, und
wobei die Druckpaste einen Stapel (150) umfasst, der aus einer Vielzahl von Schichten (150A, 150B) besteht, der als eine einzige Stapelreihe (160), welche die Vielzahl von Schichten (160A, 160B) umfasst, auf das Empfangssubstrat (70) unter Verwendung einer einzigen Beleuchtung durch den Laserstrahl zu übertragen ist.

2. Musterübertragungsblatt nach Anspruch 1, wobei mindestens zwei der Pastenschichten unterschiedliche Zusammensetzungen aus einem leitfähigen Material und/oder verschiedene Materialien umfassen.

3. Musterübertragungsblatt nach Anspruch 2, wobei die mindestens zwei der Schichten umfassen:
eine untere Pastenschicht (160B), die ein Material umfasst, das ausgewählt wird, um die übertragene Stapelreihe an das Empfangssubstrat mechanisch und/oder elektrisch zu binden, wobei das Material der unteren Schicht wahlweise ausgewählt wird, um Reihen von selektiven Sendern, SE, auf dem Empfangssubstrat zu bilden, und/oder eine Sperr- und/oder Saatschicht auf dem Empfangssubstrat bereitzustellen, und wahlweise mindestens eines umfasst von: Silber, Nickel, Titan, Tantal, Legierungen und/oder Kombinationen derselben; und
mindestens eine obere Pastenschicht (160A), die ein Material umfasst, das ausgewählt wird, um eine Leitfähigkeit entlang der übertragenen Stapelreihe bereitzustellen, wobei das Material der mindestens einen oberen Schicht wahlweise ausgewählt wird, um eine Leitfähigkeit entlang der übertragenen Stapelreihe und/oder einen elektrischen Kontakt mit dem Empfangssubstrat bereitzustellen, und wahlweise Silberpaste und/oder Kupfer umfasst.

4. Musterübertragungsblatt nach Anspruch 3, wobei eine Dicke der unteren Schicht zwischen 1 und 5 µm oder zwischen 1 und 2 µm liegt.

5. Musterübertragungsblatt nach Anspruch 3 oder 4, wobei die untere Schicht eine Materialzusammensetzung umfasst, die ausgewählt wird, um die Abgabe des mehrschichtigen Pastenstapels zu verbessern.

6. Musterübertragungsblatt nach einem der Ansprüche 1 bis 5, wobei die Gräben innen mit einer Beschichtung beschichtet sind, die dazu konfiguriert ist, sich bei der Beleuchtung aufzulösen, die für die Abgabe der Paste angewendet wird, um die Abgabe des mehrschichtigen Pastenstapels zu verbessern.

7. Musterübertragungsblatt nach einem der Ansprüche 1 bis 6, wobei das Musterübertragungsblatt für die Laserbeleuchtung transparent ist, die Gräben einen beliebigen Querschnitt von trapezförmig, rechteckig, abgerundet oder dreieckig aufweisen, und die Gräben in das Musterübertragungsblatt durch Druckformen, pneumatisches Formen, Laserformen oder Prägen gebildet werden.

8. Musterübertragungsblatt nach Anspruch 7, wobei das Musterübertragungsblatt mindestens eine Polymerschicht (112, 114) umfasst, die aus mindestens einem besteht von: Polyethylen, Polypropylen, Polyethylenterephthalat, Polybutylenterephthalat, Polyethylennaphthalat, vollaromatischem Polyester, aromatischem und aliphatischem Copolyester, Copolymer-Acrylat, Polycarbonat, Polyamid, Polysulfon, Polyethersulfon, Polyetherketon, Polyamidimid, Polyetherimid, aromatischem Polyimid, alizyklischem Polyimid, fluoriertem Polyimid, Zelluloseacetat, Zellulosenitrat, aromatischem Polyamid, Polyvinylchlorid, Polyphenol, Polyarylat, Polyphenylensulfid, Polyethylenoxid oder Polystyrol.

9. Musterübertragungsverfahren (200), umfassend:
schichtweises Einfüllen (210) einer Stapelreihe (150), die aus einer Vielzahl von Druckpastenschichten (150A, 150B) besteht, in eine Vielzahl von Gräben (110) auf einem Quellsubstrat (100), wobei die Gräben in einem Muster angeordnet werden und eine einheitliche Tiefe aufweisen, und
Abgeben (220), unter Verwendung eines einzigen Beleuchtungsschritts, der Stapelreihe aus den Gräben auf ein Empfangssubstrat (70) über Beleuchtung mit einem Laserstrahl (80).

10. Musterübertragungsverfahren nach Anspruch 9, wobei das Einfüllen durch eine Vielzahl von Messern (145), nämlich eines pro Druckpastenschicht, erfolgt, und das Musterübertragungsverfahren ferner das Anpassen einer Dicke mindestens einer der Druckpastenschichten durch Anpassen mindestens eines umfasst von: einem Druck, der auf das jeweilige Messer ausgeübt wird, einem Messerwinkel des jeweiligen Messers, einer Messergeschwindigkeit des jeweiligen Messers und/oder einer Biegsamkeit des jeweiligen Messers.

11. Musterübertragungsverfahren nach Anspruch 10, wobei der Druck zwischen 2 und 4 bar ausgewählt wird, der Messerwinkel zwischen 30° und 120° ausgewählt wird, die Messergeschwindigkeit zwischen 25 und 100 mm/s ausgewählt wird, und/oder ein Material des Messers aus Edelstahl, Kunststoff und Kautschuk ausgewählt wird.

12. Musterübertragungsverfahren nach einem der Ansprüche 9 bis 11, wobei mindestens zwei der Druckpastenschichten auf dem Empfangssubstrat unterschiedliche Materialien umfassen, die ausgewählt werden aus:
einer unteren Schicht (160B), die ein Material umfasst, das dazu konfiguriert ist, die übertragene Stapelreihe (160) an das Empfangssubstrat zu binden, und mindestens einer oberen Schicht (160A), die ein Material umfasst, das dazu konfiguriert ist, eine Leitfähigkeit entlang der übertragenen Stapelreihe bereitzustellen,
einer unteren Schicht, die ein Material umfasst, das dazu konfiguriert ist, Reihen von selektiven Sendern, SE, auf dem Empfangssubstrat zu bilden, und mindestens einer oberen Schicht, die dazu konfiguriert ist, eine Leitfähigkeit entlang der übertragenen Stapelreihe und einen elektrischen Kontakt mit dem Empfangssubstrat bereitzustellen, und/oder
einer unteren Schicht, die ein Material umfasst, das dazu konfiguriert ist, eine Sperr- und/oder Saatschicht auf dem Empfangssubstrat bereitzustellen, und mindestens einer oberen Schicht, die ein Material umfasst, das dazu konfiguriert ist, eine Leitfähigkeit entlang der übertragenen Stapelreihe bereitzustellen, wobei die untere Schicht wahlweise eine Materialzusammensetzung zur Abgabe umfasst.

13. Musterübertragungsverfahren nach einem der Ansprüche 9 bis 12, ferner umfassend:
vor dem Einfüllen, inneres Beschichten (230) der Gräben mit einer Beschichtung (120), die dazu konfiguriert ist, sich bei der Beleuchtung aufzulösen, um die Abgabe des Stapels zu verbessern, und
wahlweise nach dem Abgeben, Reinigen (240) des Empfangssubstrats durch Entfernen von der Beschichtung der Auflöseprodukte derselben.

14. Musterübertragungsverfahren nach Anspruch 13, wobei die Beschichtung durch mindestens eines erfolgt von:
Verteilen einer Beschichtungslösung, die einen Feststoffgehalt zwischen 10 % und 20 % aufweist, und Trocknen derselben; und
mindestens einem von: Gravur, Mikrogravur, Übertragungswalze, Schlitzextrusion, umgekehrte Komma-Rakel, Mayer-Stab und/oder Abstreichmesser, wobei wahlweise das Reinigen durch mindestens eines erfolgt von: Hochtemperaturzersetzung, wahlweise durch eine Beleuchtung, die wie die Beleuchtung, die zum Abgeben des Stapels verwendet wird, ist, selektiver Laserverdampfung, vakuumunterstützter Verdampfung, Luftblasen und/oder Lösemittelwaschen.

15. Photovoltaische Solarzelle (72), umfassend das Empfangssubstrat (70) mit mindestens einer der Reihen von mehrschichtigen Stapeln (160), die durch das Musterübertragungsverfahren nach einem der Ansprüche 9 bis 14 darauf übertragen wird, wobei die mindestens eine mehrschichtige Stapelreihe die Vielzahl von Druckpastenschichten (160A, 160B) umfasst.

## Revendications

1. Feuille de transfert de motif (100), comprenant :
une pluralité de tranchées (110) dans un film polymère (114),
dans laquelle les tranchées sont agencées selon un motif, présentent une profondeur uniforme et sont remplies de pâte d'impression,
dans laquelle les tranchées dans la feuille de transfert de motif sont configurées pour faciliter la libération de la pâte d'impression des tranchées sur un substrat de réception lors de l'éclairage de la feuille de transfert de motif par un faisceau laser (80), et
dans laquelle la pâte d'impression comprend une pile (150) composée d'une pluralité de couches (150A, 150B), qui est à transférer comme une ligne de piles unique (160) qui comprend la pluralité de couches (160A, 160B) sur le substrat de réception (70) en utilisant un éclairage unique par le faisceau laser.

2. Feuille de transfert de motif selon la revendication 1, dans laquelle au moins deux des couches de pâte comprennent différentes compositions matérielles conductives et/ou différents matériaux.

3. Feuille de transfert de motif selon la revendication 2, dans laquelle les au moins deux des couches comprennent :
une couche de pâte inférieure (160B) qui comprend un matériau sélectionné pour lier, mécaniquement ou électriquement, la ligne de piles transférée au substrat de réception, dans laquelle le matériau de couche inférieure est en option sélectionné pour former des lignes d'émetteurs sélectifs, SE, sur le substrat de réception et/ou pour fournir une couche de barrière et/ou d'ensemencement sur le substrat de réception, et comprend en option au moins un élément parmi : l'argent, le nickel, le titane, le tantale, des alliages et/ou des combinaisons de ceux-ci ; et
au moins une couche de pâte supérieure (160A) qui comprend un matériau sélectionné pour fournir de la conductivité le long de la ligne de piles transférée, le matériau de ladite au moins une couche supérieure étant en option sélectionné pour fournir de la conductivité le long de la ligne de piles transférée et/ou un contact électrique avec le substrat de réception, et comprend en option une pâte d'argent et/ou du cuivre.

4. Feuille de transfert de motif selon la revendication 3, dans laquelle une épaisseur de la couche inférieure est comprise entre 1 et 5 µm ou entre 1 et 2 µm.

5. Feuille de transfert de motif selon la revendication 3 ou 4, dans laquelle la couche inférieure comprend une composition matérielle sélectionnée pour améliorer la libération de la pile de pâte multicouche.

6. Feuille de transfert de motif selon l'une quelconque des revendications 1 à 5, dans laquelle les tranchées sont revêtues en interne par un revêtement configuré pour se désintégrer lors de l'éclairage appliqué pour la libération de la pâte, afin d'augmenter la libération de la pile de pâte multicouche.

7. Feuille de transfert de motif selon l'une quelconque des revendications 1 à 6, dans laquelle la feuille de transfert de motif est transparente pour l'éclairage laser, les tranchées présentent une section transversale quelconque parmi trapézoïdale, rectangulaire, arrondie ou triangulaire, et les tranchées sont formées dans la feuille de transfert de motif par moulage par compression, moulage pneumatique, moulage au laser ou gaufrage.

8. Feuille de transfert de motif selon la revendication 7, dans laquelle la feuille de transfert de motif comprend au moins une couche polymère (112, 114) qui est composée d'au moins un élément parmi : le polyéthylène, le polypropylène, le téréphtalate de polyéthylène, le téréphtalate de polybutylène, le polynaphtalate d'éthylène, le polyester entièrement aromatique, le copolyester aromatique et aliphatique, l'acrylate de copolymère, le polycarbonate, le polyamide, le polysulfone, le polyéther sulfone, le polyéther cétone, le polyamideimide, le polyétherimide, le polyimide aromatique, le polyimide alicyclique, le polyimide fluoré, l'acétate de cellulose, le nitrate de cellulose, le polyamide aromatique, le chlorure de polyvinyle, le polyphénol, le polyarylate, le sulfure de polyphénylène, l'oxyde de polyphénylène ou le polystyrène.

9. Procédé de transfert de motif (200), comprenant les étapes consistant à :
remplir (210), couche par couche, d'une ligne de piles (150) composée d'une pluralité de couches de pâte d'impression (150A, 150B) dans une pluralité de tranchées (110) sur un substrat source (100), dans lequel les tranchées sont agencées selon un motif et présentent une profondeur uniforme, et
libérer (220), en utilisant une étape d'éclairage unique, la ligne de piles des tranchées sur un substrat de réception (70) au moyen d'un éclairage par un faisceau laser (80).

10. Procédé de transfert de motif selon la revendication 9, dans lequel le remplissage est effectué par une pluralité de lames (145), une pour chaque couche de pâte d'impression, et le procédé de transfert de motif comprend en outre l'ajustement d'une épaisseur d'au moins une des couches de pâte d'impression par l'ajustement d'au moins un élément parmi : une pression exercée sur la lame respective, un angle de lame de la lame respective, une vitesse de lame de la lame respective, et/ou une flexibilité de la lame respective.

11. Procédé de transfert de motif selon la revendication 10, dans lequel la pression est sélectionnée entre 2 et 4 bar, l'angle de lame est sélectionné entre 30° et 120°, la vitesse de lame est sélectionnée entre 25 et 100 mm/s et/ou un matériau de lame est sélectionné parmi l'acier inoxydable, le plastique et le caoutchouc.

12. Procédé de transfert de motif selon l'une quelconque des revendications 9 à 11, dans lequel au moins deux des couches de pâte d'impression sur le substrat de réception comprennent différents matériaux, qui sont sélectionnés parmi :
une couche inférieure (160B) comprenant un matériau configuré pour lier la ligne de piles transférée (160) au substrat de réception et au moins une couche supérieure (160A) comprenant un matériau configuré pour fournir de la conductivité le long de la ligne de piles transférée,
une couche inférieure comprenant un matériau configuré pour former des lignes d'émetteurs sélectifs, SE, sur le substrat de réception, et au moins une couche supérieure configurée pour fournir de la conductivité le long de la ligne de piles transférée et un contact électrique avec le substrat de réception, et/ou
une couche inférieure comprenant un matériau configuré pour fournir une couche de barrière et/ou d'ensemencement sur le substrat de réception et au moins une couche supérieure comprenant un matériau configuré pour fournir de la conductivité le long de la ligne de piles transférée, la couche inférieure comprenant en option une composition matérielle de libération.

13. Procédé de transfert de motif selon l'une quelconque des revendications 9 à 12, comprenant en outre :
avant le remplissage, le revêtement (230) des tranchées en interne avec un revêtement (120) configuré pour se désintégrer lors de l'éclairage afin d'améliorer la libération de la pile, et
en option après la libération, le nettoyage (240) du substrat de réception par l'enlèvement du revêtement des produits de désintégration de celui-ci.

14. Procédé de transfert de motif selon la revendication 13, dans lequel le revêtement est effectué par au moins un élément parmi : l'étalement d'une solution de revêtement présentant une teneur en solides comprise entre 10 % et 20 % et le séchage de celle-ci, et
au moins un élément parmi : la gravure, la micro-gravure, un rouleau de transfert, une extrusion à rainures, une lame à virgule inversée, une tige de Mayer et/ou une racle, dans lequel, en option, le nettoyage est effectué par au moins un élément parmi : une décomposition haute température, en option par le même éclairage que l'éclairage utilisé pour libérer la pile, une vaporisation au laser sélective, une vaporisation assistée sous vide, un soufflage d'air et/ou un lavage aux solvants.

15. Cellule solaire photovoltaïque (72), comprenant le substrat de réception (70) avec au moins l'une des lignes de piles multicouches (160) transférée sur celui-ci par le procédé de transfert de motif selon l'une quelconque des revendications 9 à 14, ladite au moins une ligne de piles multicouches comprenant la pluralité de couches de pâte d'impression (160A, 160B).
